Europäisches Patentamt

European Patent Office

Office européen des brevets

(19)

(11) **EP 0 526 350 B1**

(12) **FASCICULE DE BREVET EUROPEEN**

(45) Date de publication et mention
de la délivrance du brevet:
**11.09.1996 Bulletin 1996/37**

(51) Int Cl.$^6$: **G06F 11/00**, G06F 11/18,
H03K 19/007

(21) Numéro de dépôt: **92420234.4**

(22) Date de dépôt: **10.07.1992**

(54) **Interface de sécurité compacte et module de vote la comportant**

Kompakte und fehlertolerante Schnittstelle und deren Verwendung in einer
Mehrheitsentscheidungsvorrichtung

Compact security interface and majority voting circuit using the same

(84) Etats contractants désignés:
**BE DE ES GB IT**

(30) Priorité: **29.07.1991 FR 9109709**

(43) Date de publication de la demande:
**03.02.1993 Bulletin 1993/05**

(73) Titulaire: **SCHNEIDER ELECTRIC SA**
**F-92100 Boulogne-Billancourt (FR)**

(72) Inventeurs:
• **Noraz, Serge**
**F-38050 Grenoble Cedex 9 (FR)**

• **Prunier, Michel**
**F-38050 Grenoble Cedex 9 (FR)**

(74) Mandataire: **Jouvray, Marie-Andrée et al**
**Schneider Electric SA,**
**Sce. Propriété Industrielle**
**38050 Grenoble Cédex 09 (FR)**

(56) Documents cités:
**EP-A- 0 183 406**          **EP-A- 0 385 885**
**DE-B- 2 900 631**

# Description

L'invention concerne une interface de sécurité compacte. Une telle interface est destinée à être utilisée dans un système à haute sûreté de fonctionnement.

Certains systèmes de sûreté font appel aux techniques de logique dynamique de sécurité. Un système de codage en fréquence à haute sécurité de fonctionnement, permettant de réduire sensiblement l'encombrement de tels systèmes est décrit dans le brevet européen EP-385.885. Ce type de système présente néanmoins l'inconvénient de nécessiter un nombre élevé de composants et de nécessiter impérativement un test périodique hors-ligne pour assurer la propriété de haute sûreté de fonctionnement ("strongly fail safe").

L'invention a pour but une interface de sécurité beaucoup moins encombrante que les systèmes faisant appel aux techniques de logique dynamique. Cette interface doit également avoir une consommation d'énergie et un nombre de composants réduits et de préférence ne pas faire appel au test périodique hors ligne pour assurer la propriété de haute sûreté de fonctionnement.

Ce but est atteint par le fait qu'elle comporte un nombre impair d'éléments inverseurs comportant chacun une entrée et une sortie, connectés en série, la sortie du dernier élément inverseur étant connectée à l'entrée du premier, chaque élément inverseur comportant des première et seconde entrées d'alimentation constituant les entrées de l'interface et sur lesquelles sont appliqués des signaux logiques binaires d'entrée de l'interface, de manière à fournir en sortie du dernier élément inverseur un signal oscillant lorsque toutes les premières entrées d'alimentation des éléments inverseurs sont alimentées par un signal de niveau logique prédéterminé et que toutes les secondes entrées d'alimentation des éléments inverseurs sont alimentées par un signal de niveau logique complémentaire du précédent, et à fournir un signal continu dans le cas contraire.

On obtient ainsi un oscillateur du type multivibrateur astable en anneau dont les entrées d'alimentation constituent les entrées fonctionnelles de l'interface. Dès que l'une des entrées n'est pas alimentée correctement, le signal de sortie de l'oscillateur est un signal continu. De plus, toute panne interne à l'interface ne modifie pas la sortie ou met celle-ci dans un état qualifié de sûr, qui correspond à la non-oscillation de l'oscillateur.

Le signal de sortie de l'oscillateur est de préférence mis en forme dans un circuit de sortie comportant un transformateur ayant un enroulement primaire connecté à la sortie du dernier élément inverseur et un enroulement secondaire connecté à la sortie de l'interface par l'intermédiaire d'un circuit redresseur.

L'association d'un dispositif de test en ligne et hors ligne à l'interface peut permettre d'augmenter la disponibilité d'un système comportant une telle interface.

Une telle interface est plus particulièrement adaptée à la constitution de modules de vote destinés à accroître à la fois la sécurité et la disponibilité d'une installation.

Selon un développement de l'invention un module de vote, connecté à au moins deux chaînes de commande indépendantes, comporte au moins une interface selon l'invention, les entrées d'alimentation d'au moins un élément inverseur de l'interface recevant respectivement un signal de données de l'une des chaînes et un signal de données complémentaires d'une autre chaîne.

Chaque chaîne de commande fournissant un signal binaire de compte-rendu et son complément à 1, ce signal de compte rendu étant audit niveau logique prédéterminé en cas de fonctionnement correct de la chaîne et au niveau logique complémentaire en cas de défaillance détectée de la chaîne, le signal de compte-rendu d'une chaîne et son complément sont respectivement appliqués sur les première et seconde entrées d'alimentation d'un autre élément inverseur de l'interface. Il est ainsi possible de valider les signaux de données transmis par une interface uniquement lorsque la ou les chaînes dont ils proviennent sont en bon état de fonctionnement, et de fournir un module de vote reconfigurable.

Selon un autre développement de l'invention, le module de vote comporte au moins une interface complémentaire comportant au moins un élément inverseur recevant sur ses entrées d'alimentation des signaux de données complémentaires en provenance d'une première chaîne de commande, un élément inverseur recevant sur ses première et seconde entrées d'alimentation respectivement le signal de compte-rendu et son complément en provenance de la première chaîne, et un élément inverseur recevant sur ses seconde et première entrées d'alimentation, respectivement le signal de compte-rendu et son complément en provenance d'une seconde chaîne, de manière à ne valider les signaux de données que lorsque la première chaîne fonctionne correctement et que la seconde chaîne est défaillante.

D'autres avantages et caractéristiques ressortiront plus clairement de la description qui va suivre de modes particuliers de réalisation de l'invention, donnés à titre d'exemples non limitatifs et représentés aux dessins annexés sur lesquels:

La figure 1 représente, sous forme de schéma bloc, une interface de sécurité compacte selon l'invention.

La figure 2 illustre un mode particulier de réalisation d'un élément inverseur de l'interface de la figure 1.

La figure 3 représente l'association d'une interface selon la figure 1 et d'un dispositif de test.

La figure 4 représente une interface associée à un bit de données délivré par deux chaînes de commande indépendantes fournissant des bits de données complémentaires.

La figure 5 illustre, sous forme schématique, un module de vote 2/3 reconfigurable constitué d'interfaces selon l'invention.

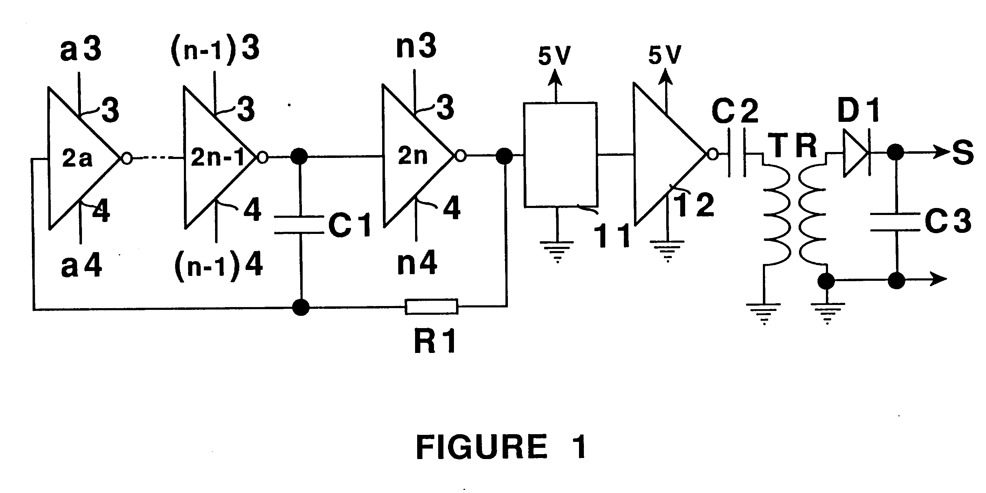

L'interface de sécurité compacte selon la figure 1 comporte un oscillateur du type multivibrateur astable en anneau constitué par un nombre impair d'éléments inverseurs 2, référencés 2a à 2n sur la figure. Ces éléments inverseurs sont connectés en série, la sortie du dernier élément inverseur 2n étant connectée à l'entrée du premier élément inverseur 2a. La fréquence d'un tel oscillateur est très élevée. Cette fréquence d'oscillation peut être réduite à une valeur prédéterminée au moyen d'un circuit RC. Dans le mode de réalisation représenté sur la figure 1, une résistance R1 est connectée en série avec un condensateur C1 entre la sortie et l'entrée de l'élément inverseur 2n, le point commun à la résistance R1 et au condensateur C1 étant connecté à l'entrée de l'élément inverseur 2a. Le même résultat peut être obtenu au moyen d'un circuit RC connecté aux bornes de n'importe quel nombre impair d'éléments inverseurs de l'oscillateur.

Chaque élément inverseur 2 comporte deux entrées d'alimentation 3 et 4. Chaque élément inverseur 2 reçoit sur ses entrées d'alimentation des signaux logiques d'entrée de l'interface, respectivement a3 à n3 sur les entrées d'alimentation 3 des éléments inverseurs 2a à 2n et a4 à n4 sur les entrées d'alimentation 4 correspondantes.

Les signaux d'entrée de l'interface sont des signaux logiques binaires. Pour qu'il y ait oscillation, il est nécessaire que tous les signaux a3 à n3, appliqués sur les entrées d'alimentation 3 ait une même valeur logique, par exemple 1, et que tous les signaux, a4 à n4, appliqués sur les entrées d'alimentation 4 ait une même valeur logique complémentaire de la précédente, 0 dans l'exemple considéré. Dès qu'un des signaux d'entrée ne répond pas à ces conditions, l'élément inverseur correspondant est bloqué et il n'y a plus oscillation.

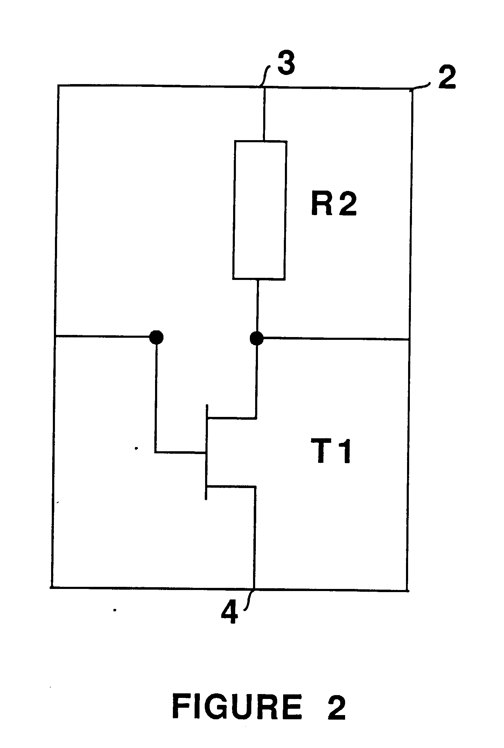

Le mode de réalisation particulier d'un élément inverseur 2 représenté à la figure 2 comporte un transistor T1, par exemple de type MOS, et un élément résistif R2 connectés en série entre les entrées d'alimentation 3 et 4. Leur point commun est connecté à la sortie de l'inverseur, tandis que l'entrée de l'inverseur est connectée a la grille du transistor. Pour fonctionner correctement l'inverseur 2 est alimenté par un signal logique 1 sur son entrée 3 et par un signal logique 0 complémentaire sur son entrée 4. Si un signal logique 1 est présent à l'entrée de l'inverseur, le transistor T1 est conducteur, et la sortie est portée au niveau logique 0. Inversement, si un signal logique 0 est appliqué à l'entrée de l'inverseur, le transistor T1 est bloqué, et la sortie est portée au niveau logique 1.

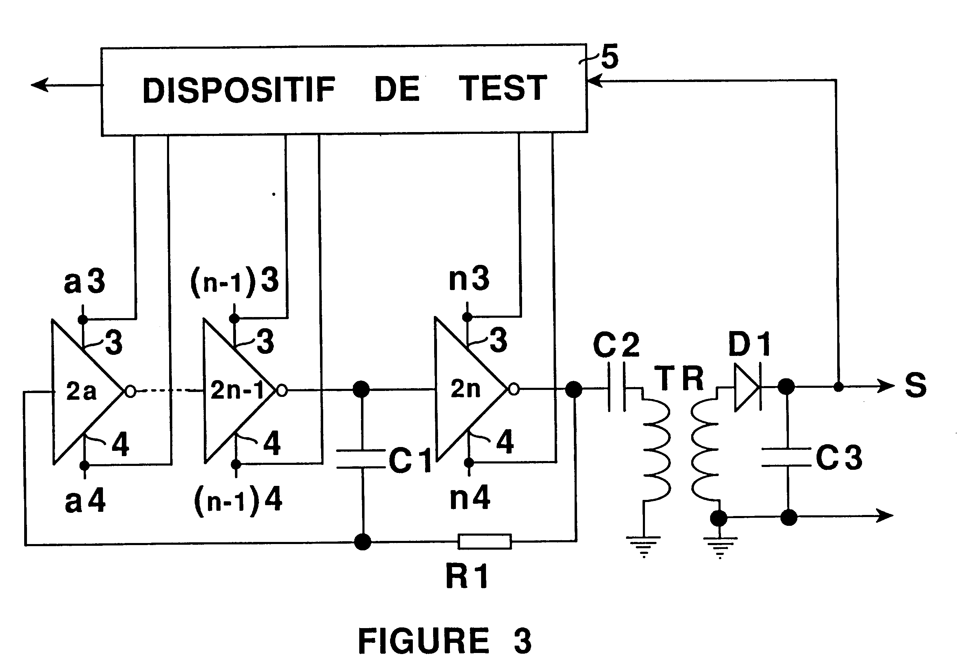

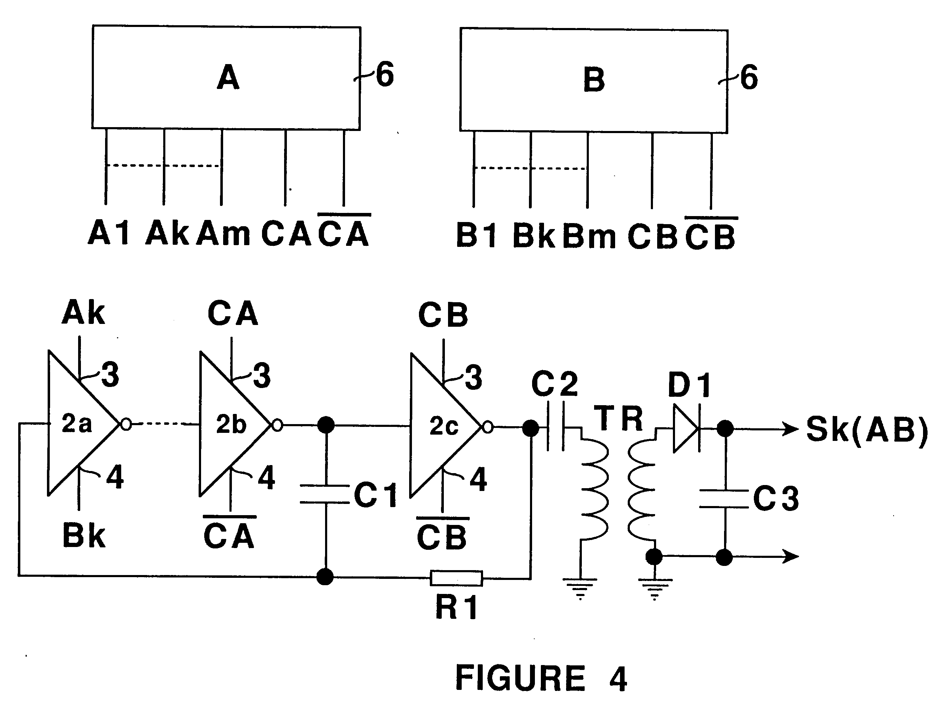

A la sortie de l'oscillateur, l'interface (figure 1) comporte un circuit de sortie destiné à mettre en forme le signal de sortie de l'oscillateur. Lorsque l'on utilise des inverseurs selon la figure 2, il est souhaitable d'amplifier le signal de sortie de l'oscillateur et le circuit de sortie comporte alors un circuit de mise en forme 11 dont la sortie est connectée à l'entrée d'un amplificateur 12, et ce circuit de sortie comporte un transformateur d'impulsions TR dont l'enroulement primaire est connecté à la sortie de l'amplificateur 12 par l'intermédiaire d'un condensateur C2 destiné à assurer la démagnétisation du transformateur. Le circuit de mise en forme 11 et l'amplificateur 12 (non représentés sur les figures 3 et 4) sont alimentés par une tension d'alimentation appropriée, par exemple 5V. Le signal recueilli aux bornes de l'enroulement secondaire du transformateur est redressé pour fournir un signal S de sortie de l'interface. Sur la figure 1 le redressement est obtenu au moyen d'une diode D1, connectée en série avec l'enroulement secondaire, et d'un condensateur C3 connecté en parallèle sur la sortie de l'interface.

En l'absence de panne intrinsèque à l'interface et lorsque les signaux logiques d'entrée sont au niveau logique 1 sur les entrées 3 des éléments inverseurs et au niveau logique 0 sur leurs entrées 4, l'oscillateur fonctionne et un signal oscillant est appliqué aux bornes de l'enroulement primaire du transformateur. Ce signal est redressé au secondaire du transformateur et le signal S de sortie de l'interface a un niveau haut et continu de tension (niveau logique 1), par exemple 5V.

Par contre, si l'oscillateur ne fonctionne pas, un signal continu est présent à sa sortie et ce signal continu est transformé par le transformateur en un signal de tension continue de niveau bas (niveau logique 0), soit 0V.

Si l'on désigne arbitrairement le niveau 0, niveau bas et continu de tension, du signal S de sortie de l'interface comme un état sûr et son niveau 1, niveau haut et continu, comme un état non sûr, on peut montrer que l'interface décrite ci-dessus a, de par sa conception, la propriété d'être un système à haute sûreté de fonctionnement ("strongly fail safe"), c'est à dire un système qui reste sûr, même en présence de pannes multiples. Autrement dit, quels que soient les signaux d'entrée (a3 à n3, a4 à n4) appliqués à l'interface, une panne simple (court-circuit, circuit ouvert...) interne à l'interface conduit à placer la sortie S,

- soit dans l'état sûr, c'est à dire au niveau 0,
- soit dans l'état correspondant aux signaux d'entrée, c'est à dire au niveau 1 si les signaux a3 à n3 sont au niveau 1 et les signaux a4 à n4 au niveau 0, et au niveau 0 si au moins l'un des signaux a3 à n3 est au niveau 0 ou si au moins l'un des signaux a4 à n4 est au niveau 1.

Il en est de même en présence d'une seconde panne interne à l'interface ou de pannes multiples.

L'interface peut être associée à un dispositif de test 5 (figure 3) destiné à détecter une panne interne à l'interface. Dans ce but, le dispositif de test, connecté aux entrées 3 et 4 des éléments inverseurs de l'interface et à la sortie S de l'interface, vérifie la cohérence entre les valeurs des signaux d'entrée de l'interface et la valeur de son signal de sortie.Une panne dans l'interface ne modifiant pas le fonctionnement de celle-ci ou conduisant à un état sûr, niveau bas du signal S dans l'exemple décrit ci-dessus, le dispositif de test détecte les pannes conduisant à l'état sûr alors que la sortie devrait être au niveau haut, c'est à dire lorsque les entrées a3 à n3 sont à 1 et les entrées a4 à n4 à 0. Ce test est réalisé en ligne, c'est à dire qu'il n'intervient pas sur le fonctionnement de l'interface et la détection d'une panne dans l'interface est signalée par le dispositif de test à un organe de surveillance approprié. En effet une panne de ce type, si elle ne remet pas en cause la sécurité du système, rend indisponible les données devant être transmises par l'interface. La duplication des interfaces, chacune associée à un dispositif de test, permet d'assurer non seulement la sécurité du système mais également sa disponibilité.

Pour permettre la détection d'une panne de l'interface même lorsque les entrées a3 à n3 restent à 0 et les entrées a4 à n4 à 1 pendant un temps assez long, le dispositif de test est conçu de manière à effectuer périodiquement un test hors ligne. Il applique, pendant une durée prédéterminée, très inférieure à la durée d'un signal binaire d'entrée, simultanément un signal 1 sur les entrées 3 et un signal 0 sur les entrées 4 de l'interface. Si le signal de sortie S est à 0 il passe alors à l'état 1 en l'absence de panne interne à l'interface. La durée du test hors ligne est suffisamment courte par rapport à la durée normale d'un bit pour que toute modification du signal S soit considérée comme une perturbation par un système disposé en aval de l'interface. Par contre, le passage à 1 du signal S est détecté par le dispositif de test, qui signale la panne en son absence.

Les données appliquées à l'interface peuvent être constituées par les données de sortie d'un automate, d'un calculateur, ou d'une chaîne de commande. Si ces données sont des données binaires, codées double rail, c'est à dire des données dans lesquelles chaque bit est associé à son complément , une interface est associée à chaque bit de données. Dans le mode de réalisation minimum, cette interface ne comporte qu'un seul élément inverseur dont la sortie est connectée à l'entrée et recevant sur son entrée d'alimentation 3 le bit considéré, et sur son entrée d'alimentation 4 son complément. Dans la pratique une telle chaîne de commande comporte un circuit chien de garde, destiné à détecter toute défaillance de la partie fonctionnelle de la chaîne. Le circuit chien de garde fournit un bit de compte-rendu C et son complément $\overline{C}$ . Le bit de compte-rendu et son complément sont alors appliqués respectivement sur les entrées 3 et 4 d'un second élément inverseur de l'interface, de manière à valider ou non les données fournies par la chaîne de commande. L'interface devant comporter un nombre impair d'éléments inverseurs, les entrées 3 et 4 du troisième élément inverseur peuvent être portées respectivement à 1 et à 0.

Les automates, calculateurs, ou chaînes de commande fournissant des données binaires codées double rail sont complexes et coûteux. Le mode de réalisation représenté à la figure 4 permet d'obtenir le même résultat à partir de 2 chaînes de commande standard. Sur cette figure, deux chaînes de commande 6 sont respectivement référencées A et B. La chaîne A délivre des données binaires A1,..Ak,...Am, ainsi qu'un bit de compte-rendu CA et son complément $\overline{CA}$ représentatifs du bon fonctionnement de la chaîne. Ces données sont codées en tension, par exemple 5V pour le niveau logique 1 et 0V pour le niveau logique 0. La chaîne B délivre des données binaires B1,...Bk,...Bm, complémentaires des données fournies par la chaîne A (Bk=$\overline{Ak}$) ainsi qu'un bit de compte-rendu CB et son complément $\overline{CB}$ .

Une interface à trois éléments inverseurs 2a,2b et 2c, est associée à chaque bit de données de la chaîne A. Seule l'interface associée au bit Ak est représentée sur la figure 4. Le bit Ak est appliqué sur l'entrée 3 du premier élément inverseur 2a et son complément Bk sur l'entrée 4 correspondante. Les bits CA et $\overline{CA}$ sont respectivement appliqués sur les entrées 3 et 4 du second inverseur 2b et les bits CB et $\overline{CB}$ sur les entrées 3 et 4 du troisième inverseur 2c. L'interface constitue ainsi un module de vote 2/2. Le signal de sortie Sk (AB) de l'interface n'est au niveau 1 que si aucune panne interne à l'interface ne force la sortie à zéro et si Ak=1, Bk=0, CA=CB=1, $\overline{CA}$=$\overline{CB}$=0, c'est à dire si les données d'ordre k fournies par les chaînes A et B sont cohérentes (vote 2/2), et si leurs chiens de garde ne sont pas défaillants et n'ont pas détecté de panne affectant la partie fonctionnelle des chaînes. La sortie Sk (AB) passe au niveau 0, ou niveau sûr, dans tous les autres cas, c'est à dire

- dès que le chien de garde de l'une des chaîne signale une anomalie dans cette chaîne (CA ou CB=0),
- lorsqu'une défaillance affecte l'un des chiens de garde (CA=$\overline{CA}$ ou CB=$\overline{CB}$),
- lorsque les données fournies par les deux chaînes ne sont pas cohérentes (Ak=Bk),
- si la donnée Ak=$\overline{Bk}$=0
- si l'interface présente une panne intrinsèque la mettant dans l'état sûr indépendamment des données appliquées sur ses entrées.

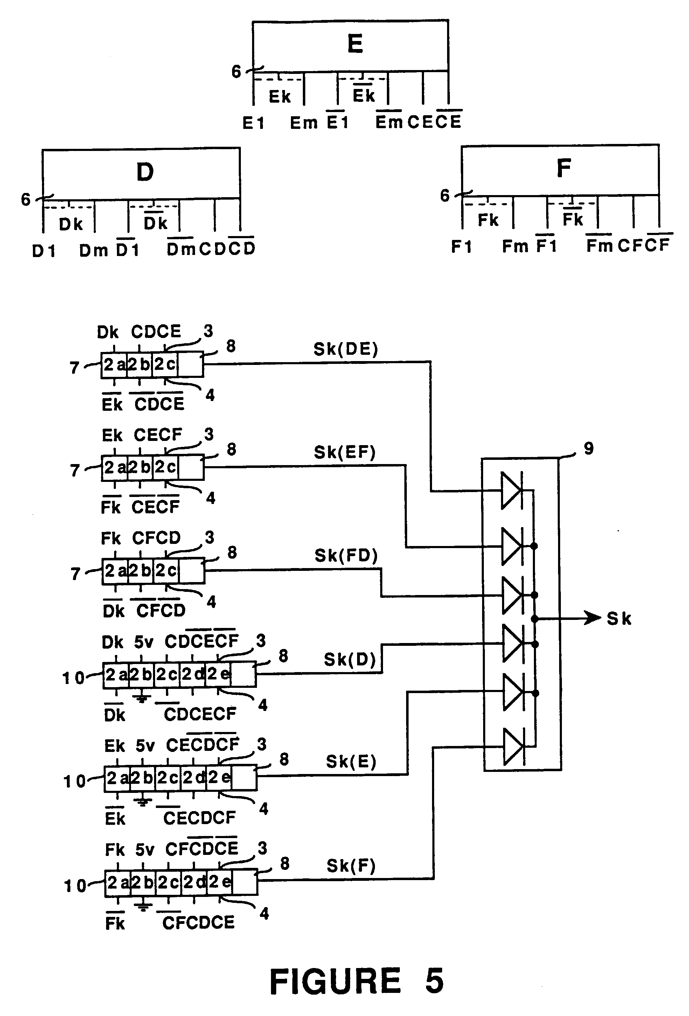

La figure 5 représente un module de vote 2/3 constitué d'une pluralité d'interfaces de sécurité compactes selon l'invention. Le module est connecté à trois chaînes de commande 6, référencées D,E et F, identiques et indépendantes. Chaque chaîne délivre des données binaires codées en tension respectivement D1...Dk... Dm, E1..Ek..Em, Fk..F1..Fm, leurs compléments à 1, un bit de compte-rendu, respectivement CD,CE et CF, et son complément à 1, $\overline{CD}$, $\overline{CE}$ et $\overline{CF}$ (codage double rail).

Le module de vote 2/3 comporte trois interfaces 7, à trois éléments inverseurs, du type représenté sur la figure 4. Afin de ne pas surcharger inutilement la figure , chaque interface a été représentée par des blocs à 2 entrées (3 et 4) correspondant au nombre d'éléments inverseurs et portant la même référence 2a,2b ou 2c que l'élément inverseur associé, et un bloc 8 représentant le circuit de sortie. L'élément inverseur 2a de la première interface 7 reçoit sur son entrée 3 le signal Dk et sur son entrée 4 le signal $\overline{EK}$. L'élément inverseur 2b reçoit les signaux CD et $\overline{CD}$ respectivement sur ses entrée 3 et 4, tandis que l'élément inverseur 2c reçoit les signaux CE et $\overline{CE}$ respectivement sur ses entrées 3 et 4. Cette interface effectue donc un vote 2/2 entre les bits Dk et $\overline{Ek}$, ces données étant validées par les bits de compte-rendu des chaînes D et E correspondantes. Le signal de sortie de cette interface a été référencé Sk (DE). De manière analogue, la seconde interface 7 produit un signal de sortie Sk(EF) correspondant à un vote 2/2 entre les bits Ek et $\overline{Fk}$, respectivement appliqués sur les entrées 3 et 4 de son premier élément inverseur 2a. Ces données sont validées par les chaînes E et F dont les bits CE et $\overline{CE}$ sont respectivement appliqués sur les entrées 3 et 4 de l'élément inverseur 2b, et les bits CF et $\overline{CF}$ sur les entrées 3 et 4 de l'élément inverseur 2c. De même la troisième interface 7 produit un signal de sortie Sk(FD) à partir des bits Fk et $\overline{DK}$ sur les entrées 3 et 4 de l'élément 2a, CF et $\overline{CF}$ sur les entrées 3 et 4 de l'élément 2b, et CD et $\overline{CD}$ sur les entrées 3 et 4 de l'élément 2c. Les sorties Sk(DE),Sk (EF) et Sk (FD) des trois interfaces sont appliquées aux entrées d'un circuit logique OU, 9, qui fournit en sortie un signal Sk de sortie du module de vote, relatif au bit de donnée d'ordre k. L'ensemble des trois interfaces et du circuit OU, de type câblé, constitué par exemple d'un simple 0U à diodes, constitue un module de vote 2/3 vis à vis de la donnée d'ordre k fournie par les trois chaînes D,E et F.

En effet, en cas de défaillance d'une des chaînes, non détectée par son chien de garde, le module fournit un signal Sk représentatif de la valeur du bit d'ordre k fourni par les deux chaînes non défaillantes. Ainsi, par exemple, si Dk=Ek=1, $\overline{Dk}=\overline{Ek}=0$, mais Fk=0 et $\overline{Fk}=1$, tandis que CD=CE=CF=1 et $\overline{CD}=\overline{CE}=\overline{CF}=0$ (défaillance de la chaîne F non détectée par son chien de garde), les interfaces 7 fournissent respectivement les signaux Sk(DE)=1, Sk(EF)=0 et Sk(FD)=0 et le signal de sortie Sk est égal à Sk(DE)=1. Inversement si Dk=Ek=0, $\overline{Dk}=\overline{Ek}=1$, Fk=1 et $\overline{Fk}=0$, on obtient Sk(DE)=Sk(EF)=Sk (FD)= 0.

Ce module de vote se reconfigure automatiquement en module de vote 2/2 lorsque l'une des chaînes est défaillante, cette défaillance étant détectée par son chien de garde. En effet, si le chien de garde de la chaîne D détecte une défaillance de cette chaîne, le bit CD devient 0 et le bit $\overline{CD}$ prend le niveau logique 1, forçant à 0 les sorties Sk (DE) et Sk(FD) des première et troisième interfaces, les éléments inverseurs recevant ces signaux, respectivement 2b et 2c, n'étant plus alimentés correctement. Seule la seconde interface fonctionne normalement, fournissant le signal Sk(EF) correspondant à un vote 2/2 entre les deux chaînes restantes.

On peut vérifier aisément que si seule la chaîne E est défaillante, seule l'interface produisant le signal Sk (FD) fonctionne normalement et que si seule la chaîne F est défaillante, c'est l'interface produisant le signal Sk (DE) qui prend le relais, assurant un vote 2/2.

Le module de vote représenté à la figure 5 comporte trois interfaces de sécurité compactes 10 complémentaires, à 5 étages. Chaque interface est du même type que celle représentée à la figure1, chaque interface étant comme précédemment schématisée par un bloc de sortie 8 et des blocs à deux entrées d'alimentation (3 et 4) correspondant aux 5 éléments inverseurs qu'elle contient et portant la même référence 2a,2b,2c,2d ou 2e, que l'élément inverseur associé.

Chaque interface 10 ne tient compte que des données provenant d'une chaîne de mesure.Les bits Dk et $\overline{Dk}$ sont respectivement appliqués aux entrées 3 et 4 de l'élément inverseur 2a de la première interface 10 qui fournit un signal Sk(D). De même, les bits Ek et $\overline{Ek}$ sont respectivement appliqués aux entrées 3 et 4 de l'élément inverseur 2a de la seconde interface 10 qui fournit un signal Sk(E) et les bits FK et $\overline{FK}$ sont respectivement appliqués aux entrées 3 et 4 de l'élément inverseur 2a de la troisième interface 10 qui fournit un signal Sk(F). La première interface 10 n'est validée que lorsque la chaîne D fonctionne normalement, CD et $\overline{CD}$ étant appliqués respectivement aux entrées 3 et 4 d'un élément inverseur 2c, tandis qu'une défaillance a été détectée par les chiens de garde des chaînes E et F. En effet, $\overline{CE}$ et CE sont respectivement appliqués sur les entrées 3 et 4 d'un élément inverseur 2d et $\overline{CF}$ et CF sur les entrées 3 et 4 d'un élément inverseur 2e. De manière analogue, la seconde interface 10, de sortie Sk(E) n'est validée que lorsque la chaîne E fonctionne normalement (CE et $\overline{CE}$ sur les entrées 3 et 4 de $2_c$) et qu'une défaillance a été détecté par les chiens de garde des chaînes D ($\overline{CD}$ et CD sur les entrées 3 et 4 de 2d) et F ($\overline{CF}$ et CF sur les entrées 3 et 4 de 2e). La troisième interface 10, de sortie Sk(F) n'est validé que lorsque la chaîne F fonctionne correctement (CF et $\overline{CF}$ sur les entrées 3 et 4 de 2c) et qu'une défaillance a été détectée dans les chaînes D ( $\overline{CD}$ et CD sur les entrées 3 et 4 de 2d) et E (CE et CE sur les entrées 3 et 4 de 2e). Chacune des interfaces 10 comporte un élément inverseur 2b dont les entrées 3 et 4 sont respectivement portées à 5V et à la masse, de manière à comporter un nombre impair d'éléments inverseurs.

Grâce à la présence des interfaces complémentaires 10, le module de vote 2/3 de la figure 5, qui se reconfigure automatiquement en module de vote 2/2 en cas de défaillance de l'une des chaînes, ne prend plus en compte que les données de la chaîne restante lorsqu'une seconde chaîne est défaillante. Dans ce dernier cas, le fonctionnement du système est dégradé mais ceci permet d'augmenter la disponibilité de l'ensemble.

Il peut être souhaitable de signaler à un dispositif de surveillance placé en amont que le module fonctionne en vote 2/2 ou en vote 1/1. Ceci peut être réalisé par tout moyen approprié, à partir des bits de compte-rendu des trois chaînes.

Les modules de vote représentés aux figures 4 et 5 ne tiennent pas compte d'éventuelles défaillances internes d'une ou plusieurs interfaces les composant. Si l'on désire augmenter encore la disponibilité de l'ensemble, on peut utiliser dans ces modules un dispositif de test du type de celui décrit en référence à la figure 3. Ce dispositif de test peut détecter la défaillance d'une interface et on peut prévoir le remplacement de l'interface défaillante par une interface complémentaire. Pour cela, il est possible par exemple de prévoir une interface complémentaire comportant un élément inverseur mis en fonctionnement, directement ou par l'intermédiaire d'une des chaînes de mesures par un signal de défaillance produit par le dispositif de test. L'interface de sécurité compacte selon l'invention peut être complétée de manière appropriée pour valider les données appliquées sur l'un de ses éléments inverseurs en fonction d'un nombre de critères prédéterminés.

Le nombre impair, d'éléments inverseurs d'une interface varie de préférence entre 3, pour assurer la lecture d'une donnée et sa validation, et une centaine dans les cas les plus complexes.

L'ensemble des éléments inverseurs peut facilement être intégré.

## Revendications

1. Interface de sécurité compacte, caractérisée en ce qu'elle comporte un nombre (n) impair d'éléments inverseurs (2a,...,2n) comportant chacun une entrée et une sortie, connectés en série, la sortie du dernier élément inverseur (2n) étant connectée à l'entrée du premier (2a), chaque élément inverseur comportant des première (3) et seconde (4) entrées d'alimentation constituant les entrées de l'interface et sur lesquelles sont appliqués des signaux logiques binaires d'entrée de l'interface (a3 à n3, a4 à n4), de manière à fournir en sortie du dernier élément inverseur, un signal oscillant lorsque toutes les premières entrées d'alimentation (3) des éléments inverseurs sont alimentées par un signal de niveau logique prédéterminé (1) et que toutes les secondes entrées d'alimentation (4) des éléments inverseurs sont alimentées par un signal de niveau logique (0) complémentaire du précédent, et à fournir un signal continu dans le cas contraire.

2. Interface selon la revendication 1, caractérisée en ce qu'elle comporte un circuit de sortie comportant un transformateur (TR) ayant un enroulement primaire connecté à la sortie du dernier élément inverseur (2n) et un enroulement secondaire connecté à la sortie (S) de l'interface par l'intermédiaire d'un circuit redresseur (D1).

3. Interface selon la revendication 2, caractérisée en ce qu'elle comporte un condensateur (C2) connecté en série avec l'enroulement primaire du transformateur (TR) à la sortie du dernier élément inverseur (2n).

4. Interface selon l'une quelconque des revendications 1 à 3, caractérisée en ce qu'elle comporte un circuit RC (R1,C1) connecté en parallèle entre l'entrée et la sortie d'un nombre impair d'éléments inverseurs connectés en série.

5. Interface selon l'une quelconque des revendications 1 à 4, caractérisée en ce qu'elle comporte un dispositif de test (5) connecté aux entrées (3,4) et à la sortie (S) de l'interface de manière à vérifier la cohérence entre les signaux d'entrée et de sortie de l'interface et à fournir un signal de défaillance de l'interface en cas de non cohérence de ces signaux.

6. Interface selon la revendication 5, caractérisée en ce que le dispositif de test applique périodiquement sur les entrées de l'interface des signaux de test, de durée prédéterminée très inférieure à la durée d'un signal binaire d'entrée.

7. Module de vote connecté à au moins deux chaînes de commande indépendantes (A,B;D,E,F), caractérisée en ce qu'il comporte au moins une interface (7) selon l'une quelconque des revendications précédentes, les entrées d'alimentation (3,4) d'au moins un élément inverseur (2a) de l'interface recevant respectivement un signal de données (Ak; Dk,Ek,Fk) de l'une des chaînes et un signal de données complémentaires (Bk;$\overline{Ek},\overline{Fk},\overline{Dk}$) d'une autre chaîne (B; E,F,D).

8. Module de vote selon la revendication 7, caractérisé en ce que chaque chaîne de commande fournissant un signal binaire de compte-rendu (CA,CB; CD,CE,CF) et son complément à 1, ce signal de compte rendu étant audit niveau logique prédéterminé (1) en cas de fonctionnement correct de la chaîne et au niveau logique complémentaire (0) en cas de défaillance détectée de la chaîne, le signal de compte-rendu d'une chaîne et son complément sont respectivement appliqués sur les première (3) et seconde (4) entrées d'alimentation d'un autre élément inverseur de l'interface.

9. Module de vote selon la revendication 8, caractérisé en ce qu'il comporte au moins une interface complémentaire (10) comportant au moins un élément inverse (2a) recevant sur ses entrées d'alimentation (3,4) des signaux de données complémentaires ($Dk,\overline{Dk}$; $Ek,\overline{Ek}$; $Fk,\overline{Fk}$) en provenance d'une première chaîne de commande (D;E;F), un élément inverseur (2c) recevant sur ses premières (3) et seconde (4) entrées d'alimentation respectivement le signal de compte-rendu et son complément en provenance de la première chaîne, et un élément inverseur (2d,2e) recevant sur ses seconde (4) et première (3) entrées d'alimentation, respectivement le signal de compte-rendu et son complément en provenance d'une seconde chaîne, de manière à ne valider les signaux de données que lorsque la première chaîne fonctionne correctement et que la seconde chaîne est défaillante.

10. Module de vote selon l'une quelconque des revendications 7 à 9, caractérisé en ce que les première (3) et seconde (4) entrées d'alimentation d'un élément inverseur non connecté à des sorties d'une chaîne de commande sont respectivement portées audit niveau logique prédéterminé (1) et à son niveau logique complémentaire (0).

**Patentansprüche**

1. Kompakte Sicherheitsschaltung, dadurch gekennzeichnet, dass sie eine ungerade Zahl (n) von in Reihe geschalteten Pegelinvertern (2a,..., 2n) umfasst, die jeweils einen Eingang sowie einen Ausgang aufweisen, wobei der Ausgang des letzten Pegelinverters (2n) mit dem Eingang des ersten Pegelinverters (2a) verbunden ist, jeder Pegelinverter erste (3) und zweite (4) Versorgungseingänge aufweist, die die Eingänge der Sicherheitsschaltung bilden und mit logischen, binären Eingangssignalen der Sicherheitsschaltung (a3 bis n3, a4, bis n4) beaufschlagt werden, derart dass am Ausgang des letzten Pegelinverters ein Schwingungssignal bereitgestellt wird, wenn sämtliche ersten Versorgungseingänge (3) der Pegelinverter mit einem Signal mit bestimmtem Logikpegel (1) und sämtliche zweiten Versorgungseingänge (4) der Pegelinverter mit einem Signal mit in bezug zum ersten Pegel komplementärem Logikpegel (0) beaufschlagt werden, und im entgegengesetzten Fall ein Gleichspannungssignal ausgegeben wird.

2. Sicherheitsschaltung nach Anspruch 1, dadurch gekennzeichnet, dass sie eine Ausgangsschaltung mit einem Trafo (TR) aufweist, der eine an den Ausgang des letzten Pegelinverters (2n) angeschlossene Primärwicklung sowie eine über eine Gleichrichterschaltung (D1) an den Ausgang (S) der Sicherheitsschaltung angeschlossene Sekundärwicklung umfasst.

3. Sicherheitsschaltung nach Anspruch 2, dadurch gekennzeichnet, dass sie einen Kondensator (C2) aufweist, der in Reihe mit der Primärwicklung des Trafos (TR) an den Ausgang des letzten Pegelinverters (2n) angeschlossen ist.

4. Sicherheitsschaltung nach irgendeinem der Ansprüche 1 bis 3, dadurch gekennzeichnet, dass sie ein RC-Glied (R1, C1) aufweist, welches parallel zwischen den Eingang und den Ausgang einer ungeraden Zahl von in Reihe geschalteten Pegelinvertern geschaltet ist.

5. Sicherheitsschaltung nach irgendeinem der Ansprüche 1 bis 4, dadurch gekennzeichnet, dass sie eine an die Eingänge (3, 4) und an die Ausgänge (S) der Sicherheitsschaltung angeschlossene Prüfeinrichtung (5) aufweist, um die Kohärenz zwischen den Eingangssignalen und den Ausgangssignalen der Sicherheitsschaltung zu überprüfen und bei fehlender Kohärenz zwischen diesen beiden Signalen ein die Fehlerhaftigkeit der Sicherheitsschaltung anzeigendes Signal auszugeben.

6. Sicherheitsschaltung nach Anspruch 5, dadurch gekennzeichnet, dass die Prüfeinrichtung die Eingänge der Sicherheitsschaltung in regelmässigen Abständen mit Prüfsignalen einer bestimmten, wesentlich unter der Wirkdauer eines binären Eingangssignals liegenden Dauer beaufschlagt.

7. Mehrheitsentscheidungsmodul, das an mindestens zwei voneinander unabhängige Befehlsgeber (A, B; D, E, F) angeschlossen ist, dadurch gekennzeichnet, dass es mindestens eine Sicherheitsschaltung (7) gemäss einem der vorhergehenden Ansprüche enthält, wobei die Versorgungseingänge (3, 4) mindestens eines der Pegelinverter (2a) der Sicherheitsschaltung mit einem Datensignal (Ak;Dk,Ek, Fk) eines der Befehlsgeber bzw. mit einem komplementären Datensignal (Bk;$\overline{\text{Ek}}$,$\overline{\text{Fk}}$,$\overline{\text{Dk}}$) eines anderen Befehlsgebers beaufschlagt werden.

8. Mehrheitsentscheidungsmodul nach Anspruch 7, dadurch gekennzeichnet, dass jeder Befehlsgeber ein binäres Statussignal (CA,CB;CD,CE,CF) und das zugehörige Komplementärsignal ausgibt, wobei dieses Statussignal bei ordnungsgemässem Betrieb des Befehlsgebers den genannten bestimmten logischen Pegel (1) und bei erfasstem fehlerhaften Betrieb des Befehlsgebers den komplementären Pegel (0) führt und das Statussignal eines Befehlsgebers sowie das zugehörige Komplemetärsignal die ersten (3) bzw. zweiten (4) Versorgungseingänge eines anderen Pegelinverters der Sicherheitsschaltung beaufschlagen.

9. Mehrheitsentscheidungsmodul nach Anspruch 8, dadurch gekennzeichnet, dass es mindestens eine zusätzliche Sicherheitsschaltung (10) aufweist, die mindestens einen Pegelinverter (2a) umfasst, dessen Versorgungseingänge (3,4) mit von einem ersten Befehlsgeber (D;E;F) ausgegebenen komplementären Datensignalen (Dk,$\overline{\text{Dk}}$;Ek,$\overline{\text{Ek}}$;Fk,$\overline{\text{FK}}$) beaufschlagt werden, wobei ein Pegelinverter (2c) an seinen ersten (3) und zweiten (4) Versorgungseingängen mit dem vom ersten Befehlsgeber ausgegebenen Statussignal bzw. dem zugehörigen Komplementärsignal beaufschlagt wird und ein Pegelinverter (2d,2e) an seinen zweiten (4) und ersten (3) Signaleingängen mit dem von einem zweiten Befehlsgeber ausgegebenen Statussignal bzw. dem zugehörigen Komplementärsignal beaufschlagt wird, derart dass die Datensignale nur dann freigegeben werden, wenn der erste Befehlsgeber ordnungsgemäss arbeitet und der zweite Befhelsgeber einen Fehler aufweist.

10. Mehrheitsentscheidungsmodul nach irgendeinem der Ansprüche 7 bis 9, dadurch gekennzeichnet, dass die ersten (3) und zweiten (4) Versorgungseingänge eines nicht an die Ausgänge eines Befehlsgebers angeschlossenen Pegelinverters den genannten bestimmten logischen Pegel (1) bzw. den zugehörigen komplementären Pegel (0) annehmen.

**Claims**

1. A compact fail safe interface, characterized in that it comprises an odd number (n) of serially connected inverting components (2a,...,2n) each comprising an input and an output, the output of a last inverting component (2n) being connected to the input of a first one (2a), each inverting component comprising first (3) and second (4) power supply inputs constituting the interface inputs and to which binary logic interface input signals (a3 to n3, a4 to n4) are applied, so as to supply an oscillating signal on output from the last inverting component when all the first power supply inputs (3) of the inverting components are supplied by a signal of predetermined logic level (1) and all the second power supply inputs (4) of the inverting components are supplied by a signal of a logic level (0) complementary to the previous one, and so as to supply a continuous signal in the opposite case.

2. The interface according to claim 1, characterized in that it comprises an output circuit comprising a transformer (TR) having a primary winding connected to the output of the last inverting component (2n) and a secondary winding connected to the interface output (S) by means of a rectifier circuit (D1).

3. The interface according to claim 2, characterized in that it comprises a capacitor (C2) serially connected with the primary winding of the transformer (TR) to the output of the last inverting component (2n).

4. The interface according to any one of the claims 1 to 3. characterized in that it comprises an RC circuit (R1, C1) connected in parallel between the input and output of an odd number of serially connected inverting components.

5. The interface according to any one of the claims 1 to 4, characterized in that it comprises a test device (5) connected to the inputs (3, 4) and output (S) of the interface so as to check the consistency between the interface input and output signals and to supply an interface failure signal in the event of inconsistency of these signals.

6. The interface according to claim 5, characterized in that the test device applies periodically to the interface inputs test signals of a preset duration much shorter than the duration of a binary input signal.

7. A voting module connected to at least two independent control channels (A, B; D, E, F), characterized in that it comprises at least one interface (7) according to any one of the foregoing claims, the power supply inputs (3, 4) of at least one inverting component (2a) of the interface receiving respectively a data signal (Ak; Dk, Ek, Fk) from one of the channels and a complementary data signal (Bk; $\overline{Ek}$, $\overline{Fk}$, $\overline{Dk}$) from another channel (B; E, F, D).

8. The voting module according to claim 7, characterized in that each control channel supplying a binary report signal (CA, CB; CD, CE, CF) and its complement to 1, this report signal being at said predetermined logic level (1) in the case of correct operation of the channel and at the complementary logic level (0) in the case of a failure being detected in the channel, the report signal of a channel and its complement are respectively applied to the first (3) and second (4) power supply inputs of another inverting component of the interface.

9. The voting module according to claim 8, characterized in that it comprises at least one complementary interface (10) comprising at least one inverting component (2a) receiving on its power supply inputs (3,4) complementary data signals (Dk; $\overline{Dk}$; Ek; $\overline{Ek}$; Fk, $\overline{Fk}$) from a first control channel (D; E; F), an inverting component (2c) receiving on its first (3) and second (4) power supply inputs respectively the report signal and its complement originating from the first channel, and an inverting component (2d, 2e) receiving on its second (4) and first (3) power supply inputs, respectively the report signal and its complement originating from a second channel, so as to validate the data signals only when the first channel is operating correctly and the second channel has failed.

10. The voting module according to any one of the claims 7 to 9, charactenzed in that the first (3) and second (4) power supply inputs of an inverting component not connected to outputs of a control channel are respectively switched to said predetermined logic level (1) and to its complementary logic level (0).

FIGURE 1

**FIGURE 2**

**FIGURE 3**

EP 0 526 350 B1

FIGURE 4

EP 0 526 350 B1

FIGURE 5